# EUROPEAN PATENT APPLICATION

(11) **EP 3 061 546 A1**
(43) Date of publication of application: **31.08.2016**
(21) Application number: 15156465.5
(22) Date of filing: 25.02.2015
(51) Int. Cl.: B22F 3/105, G06F 17/50, G06T 3/00

(54) **METHOD FOR MANUFACTURING A PART BY MEANS OF AN ADDITIVE MANUFACTURING TECHNIQUE**

(71) Applicant: General Electric Technology GmbH, 5400 Baden (CH)
(72) Inventor: Moneta, Grzegorz, 5415 Rieden (CH); Brandl, Herbert, 79761 Waldshut-Tiengen (DE); Kotteck, Thomas, 5417 Untersiggenthal (CH); Hoebel, Matthias, 5210 Windisch (CH); Schurb, Julius, 8006 Zürich (CH); Roerig, Felix, 5400 Baden (CH)
(74) Representative: Bernotti, Andrea

(57) **Abstract**

The invention relates to a method for manufacturing a part (19') by means of an additive manufacturing technique and by post additive manufacturing process steps. A cheaper and faster serial production of such parts is achieved by said method comprising the steps of:
providing first CAD data (18) representing the final geometry of the part to be manufactured;
converting said first CAD data (18) into second morphed CAD data (19) by means of a morphing process (M), whereby said morphing process (M) takes into consideration all distortions of part geometry, which develop during the additive manufacturing process and the post additive manufacturing process steps such that the part (19') manufactured in accordance with said second morphed CAD data (19) has a geometry in accordance with said first CAD data (18); and
manufacturing said part (19') by means of said additive manufacturing technique in accordance with said second morphed CAD data (19).

## Description

### BACKGROUND OF THE INVENTION

The present invention relates to the technology of additive manufacturing. It refers to a method for manufacturing a part by means of an additive manufacturing technique.

### PRIOR ART

Additive manufacturing (AM) provides parts (or components), which are distorted in their geometry. Reason for distortion is for example the relaxation of residual stresses during heat treatments (HT) (after the additive manufacturing process) or deformation (shrinkage, warpage, etc.) occurring already during the additive manufacturing process itself. As AM processes all methods using high energetic beams (e.g. electron or laser) to metallurgically bond powder (e.g. sintering, welding, fusing) are considered. During the course of the document specific phenomenons are explained using the example AM process "selective laser melting (SLM)". However, this is not limiting generality.

In many cases such an in-situ distortion is due to a "standard" design of the part, involving transitions from thin-walled to solid sections (e.g. in turbine blades or the like), which lead to different amounts of shrinkage during the selective powder melting step in a selective laser melting (SLM) process.

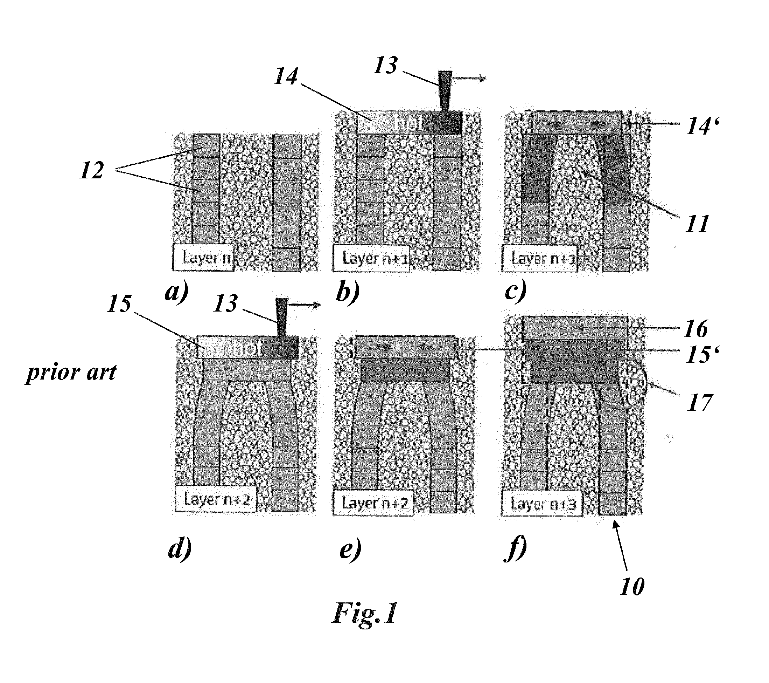

Fig. 1 shows a typical situation in an additive SLM process, wherein a part 10 is manufactured by a build-up of successive layers, which are generated by melting a powder material 11 by means of a laser beam 13.

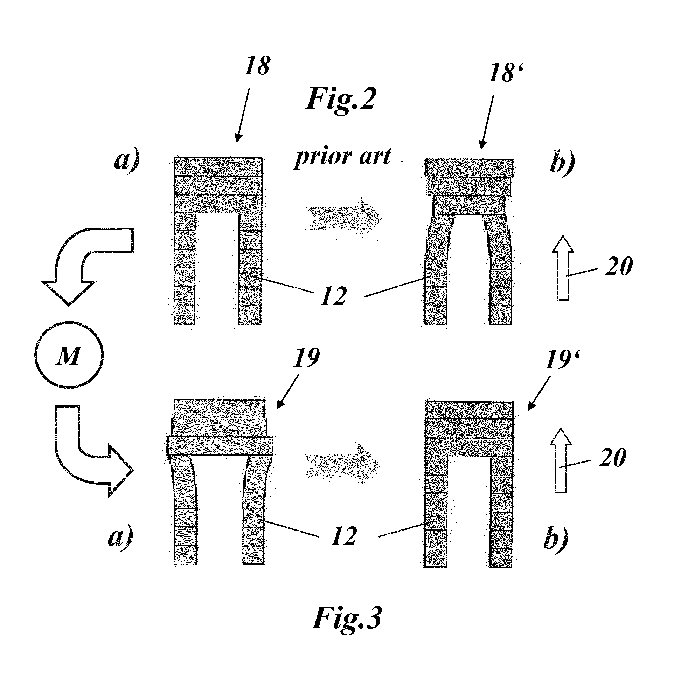

Beginning with Fig. 1(a), where n layers 12 of the part 10 have already been manufactured, a new layer (n+1) 14 is added in build direction (20 in Fig. 2 and 3) by melting a layer of said powder material 11 (Fig. 1(b)). When the new layer 14 cools down after solidification, a shrunk layer 14' results, which distorts the geometry of part 10 depending on the resistance against shrinkage provided by the adjacent layers and the surrounding powder material 11 (Fig. 1(c)).

While the side walls in the configuration of Fig. 1(c) provide less resistance against shrinkage-distortion, the situation is different for the configuration in Figs. 1(d) to (f), where further layers 15, 15' and 16 are generated on top of previous layer 14, 14'. As the resistance of bulk material against shrinkage is much higher than that of the two side walls in Fig. 1 (c), the distortion is smaller (Fig. 1 (f)) resulting in a complex transition zone 17, which in reality extends across several layers 12. In general, the geometry-deforming shrinkage results from a combined effect of consolidation of the powder material 11 and cooling of the fully consolidated (molten) material.

However, deviation from the target geometry can also result from other processing constraints, e.g. from integrated support structures for overhang sections, or from the attachment of the part to a substrate plate, which may be made of different material.

In order to get the desired geometry, a corrective manufacturing step, e.g. straightening, grinding or milling is introduced in the prior art. As an alternative, support structures can be included in the "standard" design to constrain the distortion of the part during AM or HT. Moreover, corrective manufacturing steps or additional support structures are costly and time consuming.

Thus, straightening or a CAD design with extra stock material, which needs to be post-machined, e.g. by milling or grinding, is taught by the prior art.

On the other hand, the use of morphing for an SLM processing of coupons for the reconditioning of ex-service (gas turbine) components has been disclosed in document EP 2 361 720 B1, which relates to a "Method for repairing and/or upgrading a component, especially of a gas turbine". In this document, an original CAD design of the component is morphed in order to obtain an optimum dimensional match between an SLM coupon and a distorted ex-service component. Therefore, the morphed CAD file, which is used as input for the SLM processing reproduces exactly the shape of the target component to be manufactured.

### SUMMARY OF THE INVENTION

It is an object of the present invention to provide a method for manufacturing a part by means of an additive manufacturing technique, which allows a cheaper and faster serial production of such parts.

This and other objects are obtained by a method according to Claim 1.

The inventive method for manufacturing a part by means of an additive manufacturing technique and by post additive manufacturing process steps comprises the steps of:
providing first CAD data representing the final geometry of the part to be manufactured;
converting said first CAD data into second morphed CAD data by means of a morphing process, whereby said morphing process takes into consideration all distortions of part geometry, which develop during the additive manufacturing process and post additive manufacturing process steps such that the part manufactured in accordance with said second morphed CAD data has a geometry in accordance with said first CAD data; and
manufacturing said part by means of said additive manufacturing technique in accordance with said second morphed CAD data.

According to different embodiments of the invention said additive manufacturing technique used includes selective laser melting SLM or selective electron beam melting SEBM or selective laser sintering SLS.

Specifically, said morphing process at least takes into consideration the shrinkage during cooling of the newly added hot layers during additive manufacturing process and distortions evolving from heat treatments of said manufactured part after said additive manufacturing process.

Another embodiment of the invention is characterized in that:
several parts are manufactured by said additive manufacturing method in accordance with said first CAD data;
said several manufactured parts are subjected to all other manufacturing process steps, which may distort the geometry of said manufactured parts;
the final geometry of each of said manufactured parts is recorded individually;
an average manufactured part geometry is derived from said individual geometry records;
the difference between design intent geometry according to said first CAD data and said averaged manufactured part geometry is determined;
said difference is used for said morphing process to make provisions of expected distortion caused by additive manufacturing technique.

Specifically, 3D photogrammetric scanning or CT (computer tomographic) scanning is used to record said final geometry of each of said manufactured parts.

Specifically, an arithmetic average of the recorded final geometries of said manufactured parts is used to derive said average manufactured part geometry.

An advancement of said embodiment is characterized in that:
several new parts are made by means of said additive manufacturing technique in accordance with said second morphed CAD data;
the final geometry of each of said manufactured parts is recorded individually;
an average manufactured part geometry is derived from said individual geometry records;
the difference between design intent geometry according to said first CAD data and said averaged manufactured part geometry is determined;
serial production of said parts by means of said additive manufacturing technique is started, if differences are within required limits such that no more morphing is required.

Another advancement of said embodiment is characterized in that:
several new parts are made by means of said additive manufacturing technique in accordance with said second morphed CAD data;
the final geometry of each of said manufactured parts is recorded individually;
an average manufactured part geometry is derived from said individual geometry records;
the difference between design intent geometry according to said first CAD data and said averaged manufactured part geometry is determined;
if said differences do not meet requirements said morphing process is repeated until requirements are met.

A further embodiment of the invention is characterized in that a simulation of residual stress and shrinkage during said additive manufacturing process and/or subsequent heat treatments is used to estimate the magnitude of the distortion, and that said estimated distortion is used for said morphing process to make provisions of expected distortion caused by said additive manufacturing process and/or subsequent heat treatments.

### BRIEF DESCRIPTION OF THE DRAWINGS

The present invention is now to be explained more closely by means of different embodiments and with reference to the attached drawings.
- Fig. 1: shows in a series of manufacturing steps (a) to (f) exemplary distortion effects due to shrinkage for an SLM manufacturing process according to the prior art;
- Fig. 2: shows an exemplary difference between CAD design and geometry of the manufactured part in the prior art; and
- Fig. 3: shows a respective difference between the morphed CAD design and the geometry of the manufactured part according to an embodiment of the invention.

### DETAILED DESCRIPTION OF DIFFERENT EMBODIMENTS OF THE INVENTION

The approach used in the present invention fundamentally differs from the method according to the aforementioned document EP 2 361 720 B1: In the current invention the (original) CAD file (18 in Fig. 2(a)) is morphed by a morphing process M to a morphed CAD design (19 in Fig. 3(a)) of different shape than the target component or resulting part 19'.

This is done by taking into account all deformations/distortions that will occur during the SLM processing and all relevant following post-AM manufacturing steps (e.g. removal of part from substrate plate, heat treatment HT, etc.). Therefore, although the SLM processing uses as input a CAD file 19, which has a different geometry than the target component 19', the final result (19' in Fig. 3(b)) will match very precisely with the target design (CAD design 18), while a manufacturing based on the non-morphed CAD design 18 results in a distorted part 18' (Fig. 2(b)).

In essence, the geometry of the part to be manufactured with additive manufacturing technique (AM) is morphed before manufacturing to ensure that its final shape is correct.

It is proposed to follow this morphing process M to overcome straightening/post-machining and to reduce or avoid support structures to constrain distortion:
Before serial production several of the parts 19' are produced with the additive manufacturing (AM) method. Then, the part geometry is recorded (e.g. by 3D photogrammetric scanning or by CT scanning or any other suited capturing technique). Between AM of part and geometry recording all other manufacturing process steps which may have an effect on distortion (e.g. heat treatments, hot isostatic pressing HIP, detachment of part from substrate, removal of support structures etc.) shall be included.

An average manufactured part geometry is then derived from the individual geometry records (e.g. arithmetic average). The difference between design intent geometry (CAD design 18) and averaged manufactured part geometry (of part 18') is determined. This difference is used to morph the design intent geometry (morphed CAD 19) to make provisions of expected distortion caused by the additive manufacturing technique.

With the morphed geometry 19 several new parts are made with AM.

Again the average and difference to design intent is determined analogue to the initial description.

If differences between 19' and 18 are within required limits, no more morphing is required and serial production of part with AM can start.

If differences do not meet requirements, the morphing process is repeated in further iteration loops until requirements are met.

In addition, a simulation of residual stress and shrinkage during AM or HT may be used to estimate the magnitude of the distortion. The estimated distortion is then used to morph design intent geometry and to make provisions of expected distortion caused by AM or HT.

### LIST OF REFERENCE NUMERALS

- 10: manufactured part (by additive manufacturing AM, e.g. SLM)
- 11: powder material
- 12: layer (finished)
- 13: laser or electron beam
- 14, 15: layer (hot, solidifying)
- 14', 15': layer (cool, shrunk)
- 16: layer
- 17: transition zone
- 18: CAD design (of part to be manufactured)
- 18': resulting part (after SLM)
- 19: morphed CAD design (of part to be manufactured)
- 19': resulting part (for example after SLM)
- 20: build direction
- M: morphing process

## Claims

1. Method for manufacturing a part (19') by means of an additive manufacturing technique and by post additive manufacturing process steps, comprising the steps of:
providing first CAD data (18) representing the final geometry of the part to be manufactured;
converting said first CAD data (18) into second morphed CAD data (19) by means of a morphing process (M), whereby said morphing process (M) takes into consideration all distortions of part geometry, which develop during the additive manufacturing process and the post additive manufacturing process steps such that the part (19') manufactured in accordance with said second morphed CAD data (19) has a geometry in accordance with said first CAD data (18); and
manufacturing said part (19') by means of said additive manufacturing technique in accordance with said second morphed CAD data (19).

2. Method as claimed in Claim 1, **characterized in that** said additive manufacturing technique used is selective laser melting SLM.

3. Method as claimed in Claim 1, **characterized in that** said additive manufacturing technique used is selective electron beam melting SEBM.

4. Method as claimed in Claim 1, **characterized in that** said additive manufacturing technique used is selective laser sintering SLS.

5. Method as claimed in Claim 1, **characterized in that** said morphing process (M) at least takes into consideration the shrinkage during cooling of the newly added hot layers during the additive manufacturing process and distortions evolving from treatments, such as heat treatments, of said manufactured part (19') after said additive manufacturing process.

6. Method as claimed in Claim 1, **characterized in that**:
several parts are manufactured by said additive manufacturing method in accordance with said first CAD data (18);
said several manufactured parts are subjected to all other manufacturing process steps, which may distort the geometry of said manufactured parts;
the final geometry of each of said manufactured parts is recorded individually;
an average manufactured part geometry is derived from said individual geometry records;
the difference between design intent geometry according to said first CAD data (18) and said averaged manufactured part geometry is determined;
said difference is used for said morphing process (M) to generate said second morphed CAD data (19) in order to make provisions of expected distortion caused by additive manufacturing technique.

7. Method as claimed in Claim 6, **characterized in that** 3D photogrammetric scanning or CT scanning is used to record said final geometry of each of said manufactured parts.

8. Method as claimed in Claim 6, **characterized in that** an arithmetic average of the recorded final geometries of said manufactured parts is used to derive said average manufactured part geometry.

9. Method as claimed in Claim 6, **characterized in that**:
several new parts are made by means of said additive manufacturing technique in accordance with said second morphed CAD data (19);
the final geometry of each of said manufactured parts is recorded individually;
an average manufactured part geometry is derived from said individual geometry records;
the difference between design intent geometry according to said first CAD data (18) and said averaged manufactured part geometry is determined;
serial production of said parts by means of said additive manufacturing technique is started, if differences are within required limits such that no more morphing is required.

10. Method as claimed in Claim 6, **characterized in that**:
several new parts are made by means of said additive manufacturing technique in accordance with said second morphed CAD data (19);
the final geometry of each of said manufactured parts is recorded individually;
an average manufactured part geometry is derived from said individual geometry records;
the difference between design intent geometry according to said first CAD data (18) and said averaged manufactured part geometry is determined;
if said differences do not meet requirements said morphing process is repeated until requirements are met.

11. Method as claimed in Claim 1, **characterized in that** a simulation of residual stress and shrinkage during said additive manufacturing process and/or subsequent heat treatments is used to estimate the magnitude of the distortion, and that said estimated distortion is used for said morphing process to make provisions of expected distortion caused by said additive manufacturing process and/or subsequent heat treatments.
